# EUROPEAN PATENT SPECIFICATION

(11) **EP 2 762 606 B1**
(45) Date of publication and mention of the grant of the patent: **13.04.2016**
(21) Application number: 12835109.5
(22) Date of filing: 26.04.2012
(51) Int. Cl.: C23C 14/34, C23C 14/16

(54) **Fe-Al BASED ALLOY SPUTTERING TARGET**
SPUTTERTARGET AUF FE-AI-BASIS
CIBLE DE PULVÉRISATION CATHODIQUE EN ALLIAGE À BASE DE Fe-Al

(30) Priority: 30.09.2011 JP 2011216687
(43) Date of publication of application: 06.08.2014
(73) Proprietor: JX Nippon Mining & Metals Corporation, Tokyo 100-8164 (JP)
(72) Inventor: HARADA Kentaro, Kitaibaraki-shi Ibaraki 319-1535 (JP)
(74) Representative: Hoarton, Lloyd Douglas Charles
(86) International application number: PCT/JP2012/061170
(87) International publication number: WO 2013/046780

(56) References cited:
- JP-A- H0 547 552
- JP-A- S6 324 060
- JP-A- H03 278 408
- JP-A- 2001 279 432
- JP-A- 2001 335 923
- US-A- 6 033 536
- US-A1- 2002 017 458
- IWCS, 174 MAIN STREET EATONTOWN NJ 07724 USA, 17 November 2003 (2003-11-17), XP040424877,

## Description

### TECHNICAL FIELD

The present invention relates to a sputtering target to be used for forming a magnetic thin film of a magnetic recording medium or a soft magnetic alloy sputtering target to be used in, for example, a magnetoresistive random access memory (MRAM) and relates to a Fe-Al-based sputtering target causing less abnormal discharge (micro arcing) during sputtering.

### BACKGROUND ART

Magnetic recording media have been progressing to improve the retentivity, and such progress demands high saturation magnetic flux densities of head materials for magnetic heads used in read/write. A soft magnetic material composed of a Fe-Al-based alloy has been developed under such circumstances. This soft magnetic material has a higher saturation magnetic flux density compared to ferrite used as a conventional head material and is therefore attracting attention as a magnetic head material for high image quality VTR (see Patent Document 1).

In addition to conventional materials such as Fe, Co, and Ni, a soft magnetic alloy having a high magnetic permeability, a Fe-Al-based alloy, can also be used as a soft magnetic metal material to be used in, for example, a magnetoresistive random access memory (MRAM) (see Patent Document 2).

Conventionally, these materials are utilized to form films mainly by sputtering, and therefore a target of such material is needed to perform sputtering. Since a Fe-Al-based alloy target contains Al, which is easily oxidized, grains of aluminum oxide (Al₂O₃) are formed in the target to cause, from the grains, abnormal discharge (micro arcing) and occurrence of particles during sputtering, resulting in a problem of reducing the quality of the film.

Some examples of conventional technology are shown below, but they do not disclose the problem to be solved by the present invention and do not disclose any method for solving the problem. Patent Document 1 mentioned above proposes a soft magnetic material composed of a Fe-Al-based alloy and proposes film formation by sputtering using the material as a sputtering target, wherein oxygen is added to the Fe-Al-based alloy for reducing the crystalline grain size. This is like promoting formation of aluminum oxide and has a problem of increasing abnormal discharge (micro arcing) and occurrence of particles during sputtering.

Patent Document 3 proposes a sputtering target for forming a FeAISi-based magnetic film and describes that the oxygen content is reduced to 10 ppm or less intending deoxidation for preventing degradation of the magnetic film (characteristic improvement). Furthermore, it is proposed to use Ti, Al, B, or C as the deoxidation material. In this case, it is unclear whether Al is used as an additive or a deoxidation material, or used for the both. Even in Examples, it is not specifically indicated. Furthermore, this does not indicate a concept nor description for the phenomenon of an increase of oxygen caused by addition of Al and for abnormal discharge (micro arcing) and occurrence of particles caused by oxygen in a target.

Patent Document 4 proposes a sputtering target of which oxygen content, carbon content, and nitrogen content are each controlled to be 300 ppm or less for forming a thin film that can be used in the fields of semiconductor, liquid crystal, and magnetic recording. Many materials, including a combination of Fe-Al, have been proposed as the materials for forming thin films. These materials are intended to prevent occurrence of dust and to homogenize the magnetic characteristics. However, it does not disclose the behavior of oxygen when Al is contained, and no Example showing that how much oxygen is contained in the combination of Fe-Al is disclosed. Furthermore, there is not description about abnormal discharge (micro arcing) and occurrence of particles due to oxygen during sputtering.

Use of an Al powder as a sputtering target material (Patent Document 5), use of an Al-Fe alloy sputtering target composed of soft magnetic materials (Patent Document 6), and a sputtering target for an optical recording medium composed of a combination of two or more elements selected from Fe, Al, and Si (Patent Document 7) are known, but there are no disclosure about oxygen contents and behavior of oxygen. Furthermore, there are no description about abnormal discharge (micro arcing) and occurrence of particles due to oxygen during sputtering.

Patent Document 1: Japanese Patent Laid-Open No. H5-47552
Patent Document 2: Japanese Patent Laid-Open No. 2003-297983
Patent Document 3: Japanese Patent Laid-Open No. 2001-279432
Patent Document 4: Japanese Patent Laid-Open No. 2001-335923
Patent Document 5: Japanese Patent Laid-Open No. H11-172425
Patent Document 6: Japanese Patent Laid-Open No. H8-311642
Patent Document 7: Japanese Patent Laid-Open No. 2004-284241

IWCS, 174 Main Street Eatontown NJ 07724 USA, 17 November 2003 (2003-11-17), XP040424877 discloses results on fabrication and characterization of nano-magnetic Fe, FeAl and FeAlN materials coated on metallic wires.

### SUMMARY OF INVENTION

### [Technical Problem]

It is an object of the present invention to provide a Fe-Al-based sputtering target having a reduced oxygen content, and to provide a high-density sputtering target that can reduce occurrence of the phenomenon of abnormal discharge (micro arcing) and occurrence of particles during sputtering.

### [Solution to Problem]

In order to solve the above-mentioned problems, the present inventor has diligently studied and, as a result, have found that a sputtering target of which oxygen content is reduced to a desired level can be produced.

It has been found that the thus-produced sputtering target can notably reduce abnormal discharge (micro arcing) and occurrence of particles and can improve the quality of film formation to increase the yield.

Based on these findings, the present invention provides an Fe-Al alloy sputtering target and a method of forming the same, as claimed.

### [Advantageous Effects of Invention]

The present invention provides a Fe-Al-based sputtering target having a reduced oxygen content and, thereby, has an excellent effect that the provided target can reduce occurrence of the phenomenon of abnormal discharge (micro arcing) and occurrence of particles during sputtering.

### BRIEF DESCRIPTION OF DRAWING

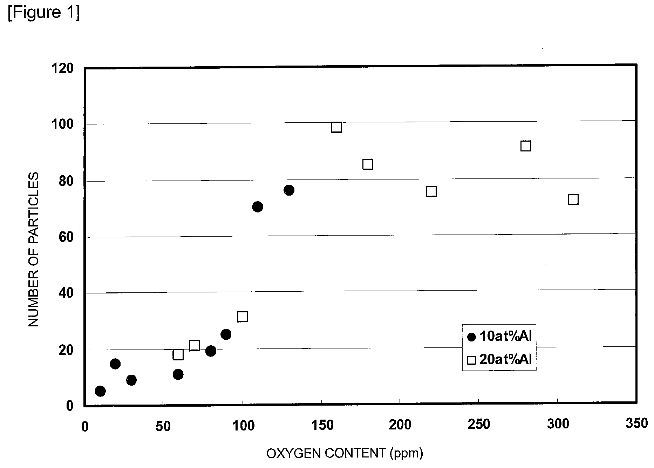

[Fig. 1] This is a graph showing a correlation between oxygen amounts and the numbers of particles.

### DESCRIPTION OF EMBODIMENTS

The Fe-Al alloy sputtering target of the present invention has an Al content of 1 to 23 at% of Al, an oxygen content of 100 wt ppm or less, and the balance being Fe and inevitable impurities. This composition is the basis of the present invention. The lower limit of the Al content, 1 at%, is a lower limit for maintaining the characteristics as an alloy and is an amount of Al that can be controlled in a usual production process.

The upper limit of the Al content is 23 at%. An Al content of higher than 23 at% provides only an intermetallic compound of Al and Fe and makes the entire material brittle. As a result, the production by casting is difficult, and cracking may occur during cooling in casting, forging, or rolling.

The oxygen is an impurity, and a lower amount thereof is better. In particular, the oxygen content is desirably 70 wt ppm or less, and more desirably 50 wt ppm or less. As described in Examples shown below, the content is an amount that can be realized in the production process of the present invention. The Al in the Fe-Al alloy is an active metal and binds with oxygen contained in a slight amount in raw materials during the process of producing a target, in particular, in the melting step, to form grains of aluminum oxide (Al₂O₃). The grains are dispersed in the sputtering target and cause abnormal discharge (micro arcing) during sputtering.

The present inventor revealed causes of abnormal discharge (micro arcing) of the Fe-Al alloy target and could reduce the frequency of occurrence of abnormal discharge (micro arcing) by decreasing the oxygen content, which allows stable operation and suppression of the number of particles, caused by abnormal discharge (micro arcing), during sputtering to 35 or less, further to 20 or less.

As described above, the presence of a slight amount of oxygen is a main cause of abnormal discharge (micro arcing) through formation of grains of aluminum oxide (Al₂O₃). In addition, there are possibilities that gas components, C and N, other than oxygen also bind with aluminum to form compounds such as Al₄C₃ and AlN, respectively, and it is therefore desirable to reduce the amount of each of C and N to 100 wt ppm or less.

In a method of producing the Fe-Al alloy sputtering target of the present invention, Fe and Al raw materials are prepared to achieve 1 to 23 at% of Al and the balance being Fe and inevitable impurities, and the raw materials are melted at a melting temperature of 1200 to 1600°C and an average rate of raising temperature of 300°C/hr or more, provided that when the Al content is 15 to 23 at%, the melting is performed at a melting temperature in the range of 1400 to 1600°C and an average rate of raising temperature of 320°C/hr or more or at a melting temperature from 1200°C to less than 1400°C; and when the Al content is 1 to 15%, the melting is performed in an Ar atmosphere at a melting temperature in the range of 1200 to 1600°C and an average rate of raising temperature of 300°C/hr or more or is performed in the air at a melting temperature in the range of 1200 to 1600°C and an average rate of raising temperature of 320°C/hr or more.

After the melting and casting, the cast ingot is rolled and machined to produce a Fe-Al alloy sputtering target having an Al content of 15 to 23 at%, an oxygen content of 100 wt ppm or less, and the balance being Fe and inevitable impurities.

The oxygen amount in the production process is affected by the Al concentration. The correlation between oxygen amounts and the numbers of particles at different Al concentrations is shown in Figure 1. As shown in Figure 1, a higher Al concentration increases the acceptable oxygen amount, that is, increases the upper limit of the oxygen amount. In contrast, a lower Al concentration decreases the acceptable oxygen amount, that is, decreases the upper limit of the oxygen amount.

Accordingly, in the method of producing the Fe-Al alloy sputtering target of the present invention, the oxygen content can be 100 wt ppm or less, preferably 70 wt ppm or less, and more preferably 50 wt ppm or less. Since the oxygen amount in the target can be significantly reduced, the method can provide a target that can reduce occurrence of the phenomenon of abnormal discharge (micro arcing) and occurrence of particles during sputtering.

### [Examples]

The invention will now be described based on Examples and Comparative Examples. Note that Examples are merely exemplary examples and that the invention is not limited to these examples at all. That is, the present invention is limited only by the claims and encompasses various modifications other than the Examples, within the scope of the invention.

### (Example 1)

A Fe raw material and an Al raw material in a total amount of 10 kg were melted in a magnesia crucible to give a Fe-Al alloy having an Al content of 10 at%. The melting was performed at a melting temperature of 1200°C in an argon (Ar) atmosphere. The average rate of raising temperature was 500°C/hr. After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 10 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 5. The results are shown in Table 1.

**[Table 1]**

| | Al content | Melting temperature | Melting atmosphere | Average rate of temperature increase | Oxygen content | Particles |
|---|---|---|---|---|---|---|
| | (at%) | (°C) | | (°C/hr) | (wtppm) | (number of particles) |
| Comparative Example 1 | 10 | 1200 | the air | 300 | 110 | 70 |
| Comparative Example 2 | 10 | 1600 | the air | 300 | 130 | 76 |
| Comparative Example 3 | 20 | 1600 | Ar | 300 | 160 | 98 |
| Comparative Example 4 | 20 | 1200 | the air | 500 | 180 | 85 |
| Comparative Example 5 | 20 | 1600 | the air | 500 | 220 | 75 |
| Comparative Example 6 | 20 | 1200 | the air | 300 | 280 | 91 |
| Comparative Example 7 | 20 | 1600 | the air | 300 | 310 | 72 |
| Example 1 | 10 | 1200 | Ar | 500 | 10 | 5 |
| Example 2 | 10 | 1200 | Ar | 300 | 20 | 15 |
| Example 3 | 10 | 1600 | Ar | 500 | 30 | 9 |
| Example 4 | 10 | 1600 | Ar | 300 | 60 | 11 |
| Example 5 | 20 | 1200 | Ar | 500 | 60 | 18 |
| Example 6 | 20 | 1600 | Ar | 500 | 70 | 21 |
| Example 7 | 10 | 1200 | the air | 500 | 80 | 19 |
| Example 8 | 10 | 1600 | the air | 500 | 90 | 25 |
| Example 9 | 20 | 1200 | Ar | 300 | 100 | 31 |

### (Example 2)

A Fe raw material and an Al raw material in a total amount of 10 kg were melted in a magnesia crucible to give a Fe-Al alloy having an Al content of 10 at%. The melting was performed at a melting temperature of 1200°C in an argon (Ar) atmosphere. The average rate of raising temperature was 300°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 20 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 15. The results are also shown in Table 1.

### (Example 3)

A Fe raw material and an Al raw material in a total amount of 10 kg were melted in a magnesia crucible to give a Fe-Al alloy having an Al content of 10 at%. The melting was performed at a melting temperature of 1600°C in an argon (Ar) atmosphere. The average rate of raising temperature was 500°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 30 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 9. The results are also shown in Table 1.

### (Example 4)

A Fe raw material and an Al raw material in a total amount of 10 kg were melted in a magnesia crucible to give a Fe-Al alloy having an Al content of 10 at%. The melting was performed at a melting temperature of 1600°C in an argon (Ar) atmosphere. The average rate of raising temperature was 300°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 60 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 11. The results are also shown in Table 1.

### (Example 5)

A Fe raw material and an Al raw material in a total amount of 10 kg were melted in a magnesia crucible to give a Fe-Al alloy having an Al content of 20 at%. The melting was performed at a melting temperature of 1200°C in an argon (Ar) atmosphere. The average rate of raising temperature was 500°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 60 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 18. The results are also shown in Table 1.

### (Example 6)

A Fe raw material and an Al raw material in a total amount of 10 kg were melted in a magnesia crucible to give a Fe-Al alloy having an Al content of 20 at%. The melting was performed at a melting temperature of 1600°C in an argon (Ar) atmosphere. The average rate of raising temperature was 500°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 70 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 21. The results are also shown in Table 1.

### (Example 7)

A Fe raw material and an Al raw material in a total amount of 10 kg were melted in a magnesia crucible to give a Fe-Al alloy having an Al content of 10 at%. The melting was performed at a melting temperature of 1200°C in the air. The average rate of raising temperature was 500°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 80 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 19. The results are also shown in Table 1.

### (Example 8)

A Fe raw material and an Al raw material in a total amount of 10 kg were melted in a magnesia crucible to give a Fe-Al alloy having an Al content of 10 at%. The melting was performed at a melting temperature of 1600°C in the air. The average rate of raising temperature was 500°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 90 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 25. The results are also shown in Table 1.

### (Example 9)

A Fe raw material and an Al raw material in a total amount of 10 kg were melted in a magnesia crucible to give a Fe-Al alloy having an Al content of 20 at%. The melting was performed at a melting temperature of 1200°C in an argon (Ar) atmosphere. The average rate of raising temperature was 300°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 100 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 31. The results are also shown in Table 1.

### (Comparative Example 1)

A Fe raw material and an Al raw material in a total amount of 10 kg were melted in a magnesia crucible to give a Fe-Al alloy having an Al content of 10 at%. The melting was performed at a melting temperature of 1200°C in the air. The average rate of raising temperature was 300°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 110 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 70. The results are also shown in Table 1.

### (Comparative Example 2)

A Fe raw material and an Al raw material in a total amount of 10 kg were melted in a magnesia crucible to give a Fe-Al alloy having an Al content of 10 at%. The melting was performed at a melting temperature of 1600°C in the air. The average rate of raising temperature was 300°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 130 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 76. The results are also shown in Table 1.

### (Comparative Example 3)

A Fe raw material and an Al raw material in a total amount of 10 kg were melted in a magnesia crucible to give a Fe-Al alloy having an Al content of 20 at%. The melting was performed at a melting temperature of 1600°C in an argon (Ar) atmosphere. The average rate of raising temperature was 300°C/hr.

After the melting, an ingot was prepared by solidification in an argon (Ar) atmosphere. The ingot was rolled and was further subjected to cutting (machining) with a lathe to give a Fe-Al alloy target having a diameter of 180.0 mm and a thickness of 5.0 mm. The oxygen content measured using an offcut of the resulting target was 160 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 98. The results are also shown in Table 1.

### (Comparative Example 4)

A Fe raw material and an Al raw material in a total amount of 10 kg were melted in a magnesia crucible to give a Fe-Al alloy having an Al content of 20 at%. The melting was performed at a melting temperature of 1200°C in the air. The average rate of raising temperature was 500°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 180 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 85. The results are also shown in Table 1.

### (Comparative Example 5)

A Fe raw material and an Al raw material in a total amount of 10 kg were melted in a magnesia crucible to give a Fe-Al alloy having an Al content of 20 at%. The melting was performed at a melting temperature of 1600°C in the air. The average rate of raising temperature was 500°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 220 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 75. The results are also shown in Table 1.

### (Comparative Example 6)

A Fe raw material and an Al raw material in a total amount of 10 kg were melted in a magnesia crucible to give a Fe-Al alloy having an Al content of 20 at%. The melting was performed at a melting temperature of 1200°C in the air. The average rate of raising temperature was 300°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 280 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 91. The results are also shown in Table 1.

### (Comparative Example 7)

A Fe raw material and an Al raw material in a total amount of 10 kg were melted in a magnesia crucible to give a Fe-Al alloy having an Al content of 20 at%. The melting was performed at a melting temperature of 1600°C in the air. The average rate of raising temperature was 300°C/hr.

After the melting, an ingot was prepared by solidification in the air. The ingot was rolled and was further subjected to cutting (machining) with a lathe to give a Fe-Al alloy target having a diameter of 180.0 mm and a thickness of 5.0 mm. The oxygen content measured using an offcut of the resulting target was 310 wt ppm.

Subsequently, the target was set in a magnetron sputtering apparatus (C-3010 sputtering system, manufactured by Canon ANELVA Corporation) to perform sputtering.

Sputtering conditions were an applied power of 1 kW and an Ar gas pressure of 1.7 Pa, and presputtering was performed at 2 kWhr. Film formation onto an aluminum substrate having a diameter of 3.5 inches was performed for 20 seconds. The number of particles adhered onto the substrate was counted with a particle counter. The number of particles on this occasion was 72. The results are also shown in Table 1.

In all Examples 1 to 9, the oxygen amount was 100 wt ppm or less, and the number of particles was 31 or less.

In contrast to this, in all Comparative Examples 1 to 7, the oxygen amount was higher than 100 wt ppm, and the number of particles was larger than 100.

### INDUSTRIAL APPLICABILITY

The present invention provides a Fe-Al-based sputtering target having a reduced oxygen content and, thereby, has an excellent effect that the provided target can reduce occurrence of the phenomenon of abnormal discharge (micro arcing) and occurrence of particles during sputtering. Therefore, the target is useful as a sputtering target to be used for forming a magnetic thin film of a magnetic recording medium or as a sputtering target for forming a soft magnetic metal material thin film to be used in, for example, a magnetoresistive random access memory (MRAM).

## Claims

1. An Fe-Al alloy sputtering target, wherein the Al content is 1 to 23 at%, the oxygen content is 100 wt ppm or less, and the balance is Fe and inevitable impurities.

2. The Fe-Al alloy sputtering target according to claim 1, wherein the oxygen content is 70 wt ppm or less.

3. The Fe-Al alloy sputtering target according to claim 1, wherein the oxygen content is 50 wt ppm or less.

4. The Fe-Al alloy sputtering target according to claim 1, wherein the content of each of N and C is 100 wt ppm or less.

5. A method of producing a Fe-Al alloy sputtering target having an Al content of 1 to 23 at%, an oxygen content of 100 wt ppm or less, the balance being Fe and inevitable impurities, the method comprising:
melting Fe raw material and Al raw material at a melting temperature of 1200 to 1600°C and an average rate of raising temperature of 300°C/hr or more;
casting the melted materials to prepare an Fe-Al alloy ingot comprising 1 to 23 at% of Al, the balance being Fe and inevitable impurities; and
rolling and machining the cast ingot.

6. The method of claim 5, wherein, when the Al content is 15 to 23 at%, the melting is performed at a melting temperature in the range of 1400 to 1600°C and an average rate of raising temperature of 320°C/hr or more or at a melting temperature from 1200°C to less than 1400°C; and
when the Al content is 1 to 15%, the melting is performed:
in an Ar atmosphere at a melting temperature in the range of 1200 to 1600°C and an average rate of raising temperature of 300°C/hr or more; or
in air at a melting temperature in the range of 1200 to 1600°C and an average rate of raising temperature of 320°C/hr or more.

7. The method of producing the Fe-Al alloy sputtering target according to claim 5 or 6, wherein the oxygen content is 70 wt ppm or less.

8. The method of producing the Fe-Al alloy sputtering target according to claim 5, 6 or 7, wherein the oxygen content is 50 wt ppm or less.

## Patentansprüche

1. Fe-Al-Legierungs-Sputtertarget, worin der Al-Gehalt 1 bis 23 at% beträgt, der Sauerstoffgehalt 100 wt-ppm oder weniger beträgt und es sich beim Rest um Fe und unvermeidbare Verunreinigungen handelt.

2. Fe-Al-Legierungs-Sputtertarget nach Anspruch 1, worin der Sauerstoffgehalt 70 wt-ppm oder weniger beträgt.

3. Fe-Al-Legierungs-Sputtertarget nach Anspruch 1, worin der Sauerstoffgehalt 50 wt-ppm oder weniger beträgt.

4. Fe-Al-Legierungs-Sputtertarget nach Anspruch 1, worin der Gehalt an jedem von N und C 100 wt-ppm oder weniger beträgt.

5. Verfahren zur Herstellung eines Fe-Al-Legierungs-Sputtertargets mit einem Al-Gehalt von 1 bis 23 at%, einem Sauerstoffgehalt von 100 wt-ppm oder weniger, wobei es sich beim Rest um Fe und unvermeidbare Verunreinigungen handelt, wobei das Verfahren Folgendes umfasst:
Schmelzen von Fe-Rohstoff und Al-Rohstoff bei einer Schmelztemperatur von 1200 bis 1600 °C und einer durchschnittlichen Temperaturerhöhungsrate von 300 °C/Std. oder mehr;
Gießen der geschmolzenen Materialien, um einen Fe-Al-Legierungs-Ingot umfassend 1 bis 23 at% Al herzustellen, wobei es sich beim Rest um Fe und unvermeidbare Verunreinigungen handelt; und Walzen und Bearbeiten des gegossenen Ingots.

6. Verfahren nach Anspruch 5, worin, wenn der Al-Gehalt 15 bis 23 at% beträgt, das Schmelzen bei einer Schmelztemperatur im Bereich von 1400 bis 1600 °C und einer durchschnittlichen Temperaturerhöhungsrate von 320 °C/Std. oder mehr oder bei einer Schmelztemperatur von 1200 °C bis weniger als 1400 °C durchgeführt wird; und wenn der Al-Gehalt 1 bis 15 % beträgt, das Schmelzen wie folgt durchgeführt wird:
in einer Ar-Atmosphäre bei einer Schmelztemperatur im Bereich von 1200 bis 1600 °C und einer durchschnittlichen Temperaturerhöhungsrate von 300 °C/Std. oder mehr; oder
an der Luft bei einer Schmelztemperatur im Bereich von 1200 bis 1600 °C und einer durchschnittlichen Temperaturerhöhungsrate von 320°C/Std. oder mehr.

7. Verfahren zur Herstellung des Fe-Al-Legierungs-Sputtertargets nach Anspruch 5 oder 6, worin der Sauerstoffgehalt 70 wt-ppm oder weniger beträgt.

8. Verfahren zur Herstellung des Fe-Al-Legierungs-Sputtertargets nach Anspruch 5, 6 oder 7, worin der Sauerstoffgehalt 50 wt-ppm oder weniger beträgt.

## Revendications

1. Une cible de pulvérisation cathodique en alliage de Fe-Al, dans laquelle la teneur en Al est comprise entre 1 et 23 at%, la teneur en oxygène est égale ou inférieure à 100 ppm en poids, et le reste est du Fe et des impuretés inévitables.

2. La cible de pulvérisation cathodique en alliage de Fe-Al selon la revendication 1, dans laquelle la teneur en oxygène est égale ou inférieure à 70 ppm en poids.

3. La cible de pulvérisation cathodique en alliage de Fe-Al selon la revendication 1, dans laquelle la teneur en oxygène est égale ou inférieure à 50 ppm en poids.

4. La cible de pulvérisation cathodique en alliage de Fe-Al selon la revendication 1, dans laquelle la teneur en chacun de N et C est égale ou inférieure à 100 ppm en poids.

5. Un procédé de fabrication d'une cible de pulvérisation cathodique en alliage de Fe-Al ayant une teneur en Al comprise entre 1 et 23 at%, une teneur en oxygène égale ou inférieure à 100 ppm en poids, le reste étant du Fe et des impuretés inévitables, le procédé consistant à :
fondre la matière première Fe et la matière première Al à une température de fusion comprise entre 1200 et 1600°C et à une vitesse moyenne de montée en température supérieure ou égale à 300°C/h ;
couler les matières fondues pour préparer un lingot d'alliage Fe-Al comprenant entre 1 et 23 at% d'Al, le reste étant du Fe et des impuretés inévitables ; et laminer et usiner le lingot coulé.

6. Le procédé selon la revendication 5, dans laquelle, lorsque la teneur en Al est comprise entre 15 et 23 at%, la fusion est effectuée à une température de fusion comprise entre 1400 et 1600°C et à une vitesse moyenne de montée en température égale ou supérieure à 320°C/h ou à une température de fusion comprise entre 1200°C et moins de 1400°C ; et lorsque la teneur en Al est comprise entre 1 et 15%, la fusion est effectuée :
dans une atmosphère de Ar à une température de fusion comprise entre 1200 et 1600°C et à une vitesse moyenne de montée en température égale ou supérieure à 300°C/h ; ou
dans l'air à une température de fusion comprise entre 1200 et 1600°C et à une vitesse moyenne de montée en température égale ou supérieure à 320°C/h.

7. Le procédé de fabrication de la cible de pulvérisation cathodique en alliage de Fe-Al selon la revendication 5 ou 6, dans lequel la teneur en oxygène est égale ou supérieure à 70 ppm en poids.

8. Le procédé de fabrication de la cible de pulvérisation cathodique en alliage de Fe-Al selon la revendication 5, 6 ou 7, dans lequel la teneur en oxygène est égale ou supérieure à 50 ppm en poids.
